Europäisches Patentamt

European Patent Office

Office européen des brevets

(19)

(11) Numéro de publication: **0 091 847**
**B1**

(12)                  **FASCICULE DE BREVET EUROPEEN**

(45) Date de publication du fascicule du brevet:
**27.11.85**

(21) Numéro de dépôt: **83400574.6**

(22) Date de dépôt: **18.03.83**

(51) Int. Cl.⁴: **H 01 R 23/70**, H 05 K 7/20

(54) **Connecteur pour substrat et système de connexion électrique et de refroidissement par convection utilisant un tel connecteur.**

(30) Priorité: **26.03.82 FR 8205252**

(43) Date de publication de la demande:
**19.10.83 Bulletin 83/42**

(45) Mention de la délivrance du brevet:
**27.11.85 Bulletin 85/48**

(84) Etats contractants désignés:
**DE GB IT**

(56) Documents cités:
**EP - A - 0 028 187**
**FR - A - 2 353 148**
**GB - A - 1 081 526**

(73) Titulaire: **SOCAPEX, 10 bis, quai Léon Blum,
F-92153 Suresnes (FR)**

(72) Inventeur: **Bricaud, Hervé, THOMSON-CSF SCPI 173, bld
Haussmann, F-75379 Paris Cedex 08 (FR)**

(74) Mandataire: **Ruellan-Lemonnier, Brigitte et al,
THOMSON-CSF SCPI 173, boulevard Haussmann,
F-75379 Paris Cedex 08 (FR)**

## Description

La présente invention concerne un connecteur pour substrat comportant sur une face des composants électroniques dissipant de la chaleur et sur l'autre face un radiateur pour évacuer lesdites calories par convection, ledit connecteur étant constitué d'une embase munie de logements de contacts électriques sur lesquels viennent s'appuyer les contacts électriques correspondants du substrat, et d'un capot qui vient se rabattre sur ledit substrat. Elle concerne également un système de connexion électrique et de refroidissement par convection d'un substrat tel que défini ci-dessus.

Il est connu du brevet US-A-4314311 un connecteur de raccordement électrique et thermique pour substrat du type céramique, ledit connecteur comportant notamment une embase munie de contacts électriques sur lesquels viennent s'appuyer les contacts électriques correspondants du substrat et un capot qui se rabat sur ledit substrat, de manière à maintenir celui-ci. Un tel connecteur peut être utilisé seul mais de préférence au moins deux connecteurs sont utilisés sur deux faces opposées du substrat. Dans ce brevet, différentes variantes sont envisagées concernant l'évacuation des calories engendrées par les composants électroniques fixés sur le substrat. Selon une variante, il est prévu un radiateur solidaire du capot dont une extrémité vient en contact avec le bord du substrat. Selon une autre variante, ce radiateur se prolonge jusqu'à l'extérieur du connecteur de manière à venir en contact avec le drain thermique de la carte mère supportant ledit connecteur. Bien que ces solutions donnent satisfaction, il est également souhaitable que le radiateur utilisé soit disposé au contact du substrat sur la plus grande surface possible de manière à évacuer les calories dissipées dans les meilleures conditions. Dans ce but, il est donc préférable de disposer le radiateur sur l'ensemble d'une face du substrat, les composants étant disposés sur l'autre face. Toutefois, se pose alors le problème de la fixation du radiateur sur le substrat. Lorsque celui-ci est en matériau céramique, comme dans la majorité des cas, cette fixation du radiateur est délicate et peu fiable dans le temps. On a, en effet, constaté que la fixation du radiateur par collage, brasure, vissage, etc. ne donnait pas entière satisfaction car ces moyens ne permettent pas d'absorber les contraintes thermomécaniques engendrées par les différences existant entre les coefficients de dilatation thermique du radiateur métallique et du matériau céramique constituant le substrat. Par ailleurs, ces procédés de fixation nécessitent des interventions sur le substrat qui engendrent d'importants risques de rupture mécanique ou de courts-circuits électriques.

L'objet de l'invention est de fournir un connecteur pour substrat permettant de fixer de manière simple et démontable un radiateur disposé au dos du substrat. Dans ce but, le connecteur selon l'invention est caractérisé en ce qu'il comporte des moyens de fixation du radiateur disposés dans le capot du connecteur et qui viennent au contact dudit radiateur de manière à le maintenir solidaire du substrat lorsque le capot est rabattu sur celui-ci.

Selon une première variante de réalisation, les moyens de fixation comportent une rainure située dans le capot parallèlement au plan des contacts électriques du substrat de profondeur de préférence inférieure à celle du capot correspondant au rebord du substrat. Ces moyens de fixation correspondent à l'extrémité plane d'un radiateur à ailettes. La profondeur plus faible de cette rainure permet malgré tout de fixer le substrat avec ou sans radiateur.

Afin de permettre une fixation du radiateur également lorsque celui-ci se présente avec ses ailettes face au capot, une seconde variante de l'invention prévoit que les moyens de fixation comportent des créneaux de largeur adaptée à la distance des ailettes du radiateur et à l'épaisseur de celles-ci.

De préférence, le connecteur selon l'invention comportera à la fois la rainure selon la première variante et les créneaux selon la deuxième variante lui permettant ainsi d'être utilisé dans tous les cas de figures.

Pour permettre une fixation correcte du radiateur du substrat entre l'embase et le capot du connecteur, celui-ci comportera de préférence des moyens de blocage du capot sur l'embase en position fermée. Une forme préférentielle de réalisation de ces moyens de blocage est constituée par une pince de la manière décrite dans la demande de brevet FR-A-2475809.

L'invention sera mieux comprise à l'aide des exemples de réalisation suivants, donnés à titre non limitatif, conjointement avec les figures qui représentent:

— la fig. 1, une vue en coupe d'un système de connexion électrique et thermique selon l'invention,

— la fig. 2, une vue en coupe détaillée d'un connecteur selon l'invention,

— la fig. 3, une vue de dessus du connecteur de la fig. 2.

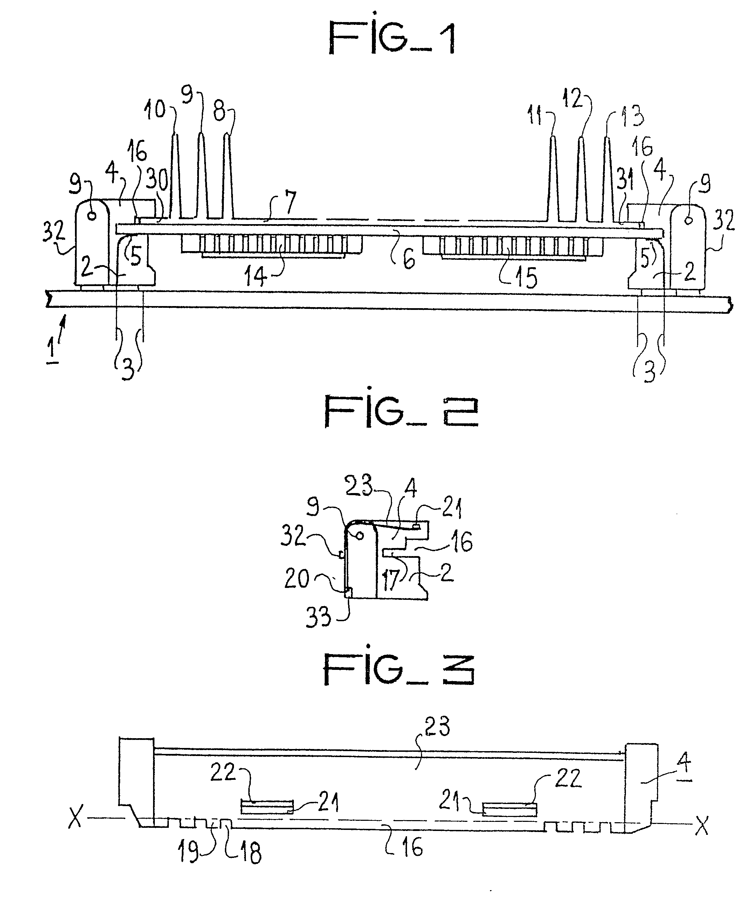

Sur la fig. 1, est représentée une vue en coupe d'un système de connexion électrique et de refroidissement par convection selon l'invention. Ce système comporte un substrat 6 connu en soi comportant d'un côté des composants électroniques 14 et 15 dissipant de la chaleur reliés par l'intermédiaire de connexions électriques aux contacts électriques 3. La connexion électrique proprement dite entre les connexions de surface et les contacts 3 s'effectue au point 5. Ces contacts 3 sont reliés à une carte mère 1 du type circuit imprimé éventuellement revêtue d'un drain thermique. Au dos du substrat 6 est disposé un radiateur 7 muni d'ailettes de refroidissement 8, 9, 10, 11, 12, 13, ... Ce radiateur 7 se termine à gauche et à droite sur la figure par une partie plane (rebord) 30, 31 qui vient s'emboîter dans une rainure 16 du capot 4 du connecteur 32. Ce capot 4 comporte également une rainure plus profonde 17 destinée au logement du substrat 6. Le capot 4 du connecteur 32 peut pivoter dans cet exemple autour de l'axe 9 de manière à venir se rabattre au-dessus du substrat 6 et du radiateur 7 comme indiqué sur la figure, ceux-ci étant soutenus par les contacts électriques 3 et l'embase 2 portant ceux-ci.

La fig. 2 montre une vue en coupe d'un connecteur 32 de la fig. 1. Les mêmes éléments que ceux de cette figure portant les mêmes références. On distingue nettement sur cette figure les deux rainures 16 et 17 d'épaisseur respectivement sensiblement égale à l'épaisseur de l'extrémité (rebord) 30 du radiateur 7 d'une part et l'extrémité du substrat 6 d'autre part. Ces rainures sont par ailleurs parallèles entre elles et parallèles à l'axe 9. Pour assurer une bonne résistance aux vibrations et un bon contact électrique et thermique, le connecteur 32 est dans cet exemple muni d'une pince de fermeture telle que décrite dans la demande FR-A-2475809 citée ci-dessus. Cette pince en forme de U comporte deux bras d'inégale longueur, l'un très court 20 qui vient se loger dans la rainure correspondante 33 située à la base de l'embase 2, l'autre beaucoup plus long 23 s'étendant jusqu'au-dessus de la zone de contact électrique 5, ce bras étant muni par ailleurs d'ouvertures 22 (fig. 3) qui coopèrent avec des tenons 21 de manière à pincer effectivement le capot sur l'embase.

La fig. 3 montre une vue de dessus du connecteur selon l'invention. Celui-ci comporte essentiellement une rainure 16 qui s'étend sur toute la longueur du capot 4 le long de l'axe XX ainsi que des indentations en forme de créneaux 18, 19. Ces indentations telles que 18 ont une largeur sensiblement égale à l'épaisseur d'une ailette telle que 10 du radiateur 7 à la base de celles-ci, tandis que les indentations telles que 19 ont évidemment une largeur sensiblement égale à la distance entre deux ailettes 9 et 10 à la base de celles-ci. Bien entendu, l'efficacité du système sera d'autant meilleure que les formes du radiateur et des indentations sont complémentaires. Ces indentations permettent donc au capot de pénétrer entre les ailettes du radiateur 7 de manière à maintenir ainsi solidairement le substrat 6 et le radiateur 7. Bien entendu, les meilleurs résultats du point de vue maintien et donc conduction thermique du système selon l'invention sont obtenus avec d'une part deux connecteurs 32 disposés en vis-à-vis, munis d'une rainure 16 telle que représentée en coupe sur la fig. 1 de manière à fixer le radiateur 7 sur le substrat 6 en plaquant le rebord 30 de celui-ci sur celui-là, et en disposant deux connecteurs tels que représentés sur la fig. 3 en vis-à-vis sur les deux faces disponibles du substrat 6, de telle sorte que les indentations 19 viennent se loger entre les ailettes du radiateur 7 et maintiennent ainsi de manière améliorée le radiateur 7 sur le substrat 6. Dans tous les cas, ces connecteurs peuvent être des connecteurs électriques tels que représentés sur la fig. 1. Ils peuvent également n'avoir qu'une fonction thermique jouant uniquement leur rôle d'une pince mécanique du radiateur 7 sur le substrat 6.

**Revendications**

1. Connecteur pour substrat comportant sur une face des composants électroniques (14, 15) dissipant de la chaleur et sur l'autre face un radiateur (7) pour dissiper lesdites calories par convection, ledit connecteur étant constitué d'une embase (2) munie de logements de contacts électriques sur lesquels viennent s'appuyer les contacts électriques (3) correspondants du substrat (6) et d'un capot (4) qui vient se rabattre sur ledit substrat (6), caractérisé en ce qu'il comporte des moyens de fixation du radiateur (7), disposés dans le capot (4) du connecteur et qui viennent au contact dudit radiateur (7) de manière à maintenir le radiateur (7) solidaire du substrat (6) lorsque le capot (4) est rabattu sur celui-ci.

2. Connecteur selon la revendication 1, caractérisé en ce que les moyens de fixation comportent une rainure (16) située dans le capot (4), parallèlement au plan des contacts électriques (3), de profondeur inférieure à celle du capot (4) correspondant au rebord du substrat (6).

3. Connecteur selon l'une des revendications 1 ou 2, caractérisé en ce que les moyens de fixation comportent des créneaux (18, 19) de largeur adaptée à la distance des ailettes (8-13, ...) du radiateur (7) et à l'épaisseur de celles-ci.

4. Connecteur selon l'une des revendications 2 ou 3, caractérisé en ce que la profondeur des créneaux (18, 19) est sensiblement égale à la profondeur de la rainure (16).

5. Système de connexion électrique de refroidissement par convection d'un substrat (6) revêtu sur une face d'une pluralité de composants électroniques (14, 15) dissipant de la chaleur, ledit substrat (6) étant muni sur sa périphérie de contacts électriques (3) qui viennent s'appuyer sur les contacts correspondants d'un connecteur muni d'une embase (2) et d'un capot (4), ledit substrat (6) étant en outre revêtu sur la face opposée à celle où se trouvent les composants (14, 15) d'un radiateur (7) destiné à évacuer par convection la chaleur dissipée par lesdits composants (14, 15), caractérisé en ce qu'il comporte au moins deux connecteurs (32) dont les capots (4) sont munis de moyens de fixation du radiateur (7), celui-ci s'étendant au-delà de la face frontale du capot (4) de chaque connecteur (32).

6. Système selon la revendication 5, caractérisé en ce qu'il comporte au moins deux connecteurs (32) en vis-à-vis.

7. Système selon l'une des revendications 5 ou 6, caractérisé en ce que les moyens de fixation du radiateur (7) sont constitués par une rainure (16) dans le capot (4), d'épaisseur égale à celle de la partie plane (30, 31) du radiateur (7) qui vient se glisser sous ledit capot (4) de manière à maintenir solidairement le substrat (6) et le radiateur (7).

8. Système selon l'une des revendications 5 à 7, caractérisé en ce que les moyens de fixation du radiateur (7) sont constitués par des indentations (18, 19) dans le capot (4), de dimensions telles que chaque dent (19) vient se loger entre deux ailettes (9, 10) du radiateur (7) qui se prolonge au-delà de la face frontale du capot (4) et s'appuie sur la surface reliant lesdites ailettes (8-13,...) de manière à rendre solidaires le radiateur (7) et le substrat (6).

## Patentansprüche

1. Verbinder für ein Substrat mit elektronischen wärmeerzeugenden Bauteilen (14, 15) auf einer Seite und einem Strahlungskühler (7) zur Ableitung dieser Wärme mittels Konvektion auf der anderen Seite, wobei der Verbinder einen Sockel (2) mit eingelegten elektrischen Kontakten, auf denen die entsprechenden elektrischen Kontakte (3) des Substrats (6) aufliegen, und eine Haube (4) aufweist, die auf das Substrat (6) heruntergeklappt wird, dadurch gekennzeichnet, dass Mittel zur Befestigung des Strahlungskühlers (7) in der Haube (4) des Verbinders vorgesehen sind, die mit dem Strahlungskühler (7) in Kontakt treten, so dass der Strahlungskühler (7) am Substrat (6) festgehalten wird, wenn die Haube (4) auf das Substrat (6) heruntergeklappt ist.

2. Verbinder nach Anspruch 1, dadurch gekennzeichnet, dass die Befestigungsmittel eine Rille (16) aufweisen, die in der Haube (4) parallel zur Ebene der elektrischen Kontakte (3) liegt und deren Tiefe geringer als die dem Rand des Substrats (6) entsprechende Rille der Haube (4) ist.

3. Verbinder nach einem der Ansprüche 1 oder 2, dadurch gekennzeichnet, dass die Befestigungsmittel Einschnitte (18, 19) aufweisen, deren Breite dem Abstand der Rippen (8 bis 13, ...) des Strahlungskühlers (7) und der Dicke dieser Rippen angepasst ist.

4. Verbinder nach einem der Ansprüche 2 und 3, dadurch gekennzeichnet, dass die Tiefe der Einschnitte (18, 19) im wesentlichen gleich der Tiefe der Rille (16) ist.

5. System zur elektrischen Verbindung und zur Konvektionskühlung eines Substrats (6), das auf einer Seite eine Vielzahl elektrischer wärmeerzeugender Bauteile (14, 15) trägt und auf seinem Umfang elektrische Kontakte (3) aufweist, die auf den entsprechenden Kontakten eines einen Sockel (2) und eine Haube (4) besitzenden Verbinders aufliegen, wobei das Substrat (6) ausserdem auf der Seite, die den Bauteilen (14, 15) entgegengesetzt ist, von einem Strahlungskühler (7) bedeckt ist, der zur Abfuhr der von den Bauteilen (14, 15) erzeugten Wärme durch Konvektion bestimmt ist, dadurch gekennzeichnet, dass es mindestens zwei Verbinder (32) enthält, deren Hauben (4) mit Mitteln zur Befestigung des Strahlungskühlers (7) versehen sind, wobei dieser Strahlungskühler sich über die Stirnseite der Haube (4) jedes Verbinders (32) hinaus erstreckt.

6. System nach Anspruch 5, dadurch gekennzeichnet, dass es mindestens zwei einander gegenüberliegende Verbinder (32) enthält.

7. System nach einem der Ansprüche 5 oder 6, dadurch gekennzeichnet, dass die Befestigungsmittel für den Strahlungskühler (7) von einer Rille (16) in der Haube (4) gebildet werden, wobei die Breite der Rille gleich der Dicke des ebenen Bereichs (30, 31) des Strahlungskühlers (7) ist und der Strahlungskühler unter diese Haube (4) eingeschoben wird, so dass das Substrat (6) und der Strahlungskühler (7) in fester Verbindung miteinander gehalten werden.

8. System nach einem der Ansprüche 5 bis 7, dadurch gekennzeichnet, dass die Befestigungsmittel für den Strahlungskühler (7) aus zahnartigen Einschnitten (18, 19) in der Haube (4) bestehen, deren Abmessungen so gewählt sind, dass jeder Zahn (19) zwischen zwei Kühlrippen (9, 10) des Strahlungskühlers (7) eingreift, wobei letzterer sich über die Stirnfläche der Haube (4) hinaus erstreckt und auf der die Kühlrippen (8-13, ...) so abstützt, dass der Strahlungskühler (7) und das Substrat miteinander fest verbunden werden.

## Claims

1. A connector for a substrate comprising on one surface heat dissipating electronic components (14, 15) and on the other surface a radiator (17) for dissipating said heat by convection, said connector being composed of a base (2) bearing electrical contacts on which the corresponding electrical contacts (3) of the substrate (6) are applied, and comprising a cap (4) which is folded back onto said substrate (6), characterized in that it comprises means for fixing the radiator (7), the means being disposed in the cap (4) of the connector and being applied against the radiator (7) in such a way that the radiator (7) is rendered integral with the substrate (6) when the cap (4) is folded back thereon.

2. A connector according to claim 1, characterized in that the means for fixing comprise a slot (16) located in the cap (4) parallely to the plane of the electrical contacts (3), the depth of this slot being smaller than that of the cap (4) and corresponding to the edge of the substrate (6).

3. A connector according to one of claims 1 or 2, characterized in that the means for fixing comprise crenels (18, 19), the width of which is adapted to the distance between the fins (8 to 13, ...) of the radiator (7) and to the thickness of these fins.

4. A connector according to one of claims 2 and 3, characterized in that the depth of the crenels (18, 19) is substantially equal to the depth of the slot (16).

5. A system for electrical connection and for convection cooling of a substrate (6) which is covered on one surface with a plurality of heat dissipating electrical components (14, 15), said substrate (6) being provided on its periphery with electrical contacts (3) which are applied against the corresponding contacts of a connector having a base (2) and a cap (4), said substrate (6) being further covered on its surface opposed to that on which the components (14, 15) are located, with a radiator (7) conceived to withdraw by convection the heat dissipated from said components (14, 15), characterized in that it comprises at least two connectors (32), the caps (4) of which are provided with means for fixing the radiator (7), this radiator extending beyond the front surface of the cap (4) of each connector (32).

6. A system according to claim 5, characterized in that it comprises at least two connectors (32) disposed vis-à-vis.

7. A system according to one of claims 5 or 6, characterized in that the means for fixing the radiator (7) comprise a slot (16) in the cap (4), the width of the slot being equal to the thickness of the plane area (30, 31) of the radiator (7), this radiator being able to slide under the cap (4) in such a way that the substrate (6) and the radiator are made integral.

8. A system according to one of the claims 5 to 7, characterized in that the means for fixing the radiator (7) comprise indentations (18, 19) in the cap (4), the dimensions of the indentations being such that each tooth (19) engages between two fins (9, 10) of the radiator (7) which extends beyond the front surface of the cap (4) and is applied on the surface connecting said fins (8-13, ...) in such a way that the radiator (7) and the substrate (6) are made integral.

# FIG_1

# FIG_2

# FIG_3